Europäisches Patentamt

European Patent Office

Office européen des brevets

(11) Numéro de publication: **0 427 611 A1**

# (12) DEMANDE DE BREVET EUROPEEN

(21) Numéro de dépôt: 90403136.6

(22) Date de dépôt: 06.11.90

(51) Int. Cl.⁵: **B07C 5/344**

(30) Priorité: 10.11.89 FR 8914774

(43) Date de publication de la demande:
15.05.91 Bulletin 91/20

(84) Etats contractants désignés:
AT CH DE FR GB IT LI

(71) Demandeur: COMPAGNIE EUROPEENNE DE
COMPOSANTS ELECTRONIQUES LCC
50, rue Jean-Pierre Timbaud
F-92400 Courbevoie(FR)

(72) Inventeur: Clemencet, Francois

THOMSON-CSF SCPI Cédex 67
F-92045 Paris la Défense(FR)
Inventeur: Lanier, Daniel
THOMSON-CSF SCPI Cédex 67
F-92045 Paris la Défense(FR)
Inventeur: Oudard, François
THOMSON-CSF SCPI Cédex 67
F-92045 Paris la Défense(FR)

(74) Mandataire: Ruellan-Lemonnier, Brigitte et al
THOMSON-CSF SCPI
F-92045 PARIS LA DEFENSE CEDEX 67(FR)

(54) Dispositif de contrôle et de tri de condensateurs chips.

(57) L'invention concerne un dispositif de mesure des grandeurs électriques caractéristiques de condensateurs du type chips et de tri de ces condensateurs en fonction des grandeurs électriques mesurées. Ce dispositif comprend deux roues rotatives tangentes (R1 et R2) permettant de transporter à leur périphérie les condensateurs à contrôler sont maintenus par aspiration. La première roue (R1) est destinée à l'alimentation et à la mesure des condensateurs tandis que la seconde roue (R2) est destinée à leur classement.

FIG_2

## DISPOSITIF DE CONTROLE ET DE TRI DE CONDENSATEURS CHIPS

La présente invention concerne un dispositif permettant de mesurer des grandeurs électriques caractéristiques de condensateurs du type chips, c'est-à-dire de composants de forme parallélépipédique destinés à être montés en surface sur un circuit imprimé. Ce dispositif doit permettre également le tri des condensateurs en fonction des grandeurs électriques mesurées.

Actuellement, les opérations qui sont nécessaires entre la sortie de la chaîne de fabrication des condensateurs chips et leur conditionnement final en vue de leur livraison aux utilisateurs sont effectuées sur des équipements totalement séparés, dont :
- un premier poste de classement des condensateurs en deux catégories ou plus : à ce poste, tous les condensateurs sans exception sont testés et, pour ceci, il est procédé à une mesure de leur capacité et à une mesure de leur angle de perte (mesure de "tangente"). Les condensateurs sont alors classés, si leur angle de perte est satisfaisant, en par exemple deux catégories :
. 1ère catégorie : condensateurs dont la capacité est égale à la capacité nominale à 5 % près ;
. 2ème catégorie : condensateurs dont la capacité est égale à la capacité nominale à 10 % près ;
- un deuxième poste où sont acheminés tous ces condensateurs, et auquel certains d'entre eux sont soumis à une mesure de résistance d'isolement ainsi qu'à une mesure de tenue au claquage ;
un troisième poste; où les condensateurs issus de ce deuxième poste sont transférés, qui est le poste de mise sur bande de livraison.

Ces installations de contrôle connues présentent quelques inconvénients. Les manutentions entre les postes successifs sont sources d'erreurs. Les mesures électriques fondamentales que sont la mesure de capacité et la mesure d'angle de perte ne sont quelquefois faites qu'une seule fois, de sorte que ce genre de dispositif n'est pas redondant, ce qui est ennuyeux. La cadence de fonctionnement est limitée, en raison surtout des manutentions consécutives aux transports d'un poste à l'autre. Enfin, il existe un risque, avec de telles installations de contrôle, que des pièces mauvaises ne soient pas détectées et éliminées, de sorte que les bandes de condensateurs peuvent contenir quelques pièces mauvaises parmi les bonnes, ce qui est très gênant.

L'invention vise à remédier à ces inconvénients. Elle se rapporte à un dispositif ou machine entièrement automatique et qui permet de mesurer, pour un condensateur de type chips, les paramètres suivants : capacité, tangente de l'angle de perte, tenue en tension et résistance d'isolement.

Le dispositif permet également le tri des condensateurs en fonction des caractéristiques mesurées et l'éjection des pièces mauvaises. Toutes les opérations de mesures se faisant sur une même machine, on évite ainsi les risques de mélange de composants dans les transferts entre dispositifs de mesure. Le dispositif selon l'invention est du type zéro défaut.

L'invention a donc pour objet un dispositif de contrôle et de tri de condensateurs chips, le dispositif possédant des moyens de transport des condensateurs à contrôler depuis une zone d'alimentation jusqu'à une zone de triage, le contrôle consistant à mesurer des caractéristiques électriques des condensateurs pendant une partie de leur transit sur les moyens de transport, caractérisé en ce que :
- les moyens de transport comprennent une première roue rotative dont l'axe de rotation fait un angle compris entre 0 et 45° par rapport à la verticale et comportant des alvéoles périphériques, chacune de ces alvéoles étant destinée à recevoir, dans la zone d'alimentation, un condensateur à contrôler, la roue comportant des moyens d'aspiration/soufflage destinés à maintenir les condensateurs dans leurs alvéoles sur sun angle de rotation déterminé de la roue et à les éjecter en un point déterminé dit point d'éjection,
- la mesure des caractéristiques électriques se fait par des moyens de prise de contact électrique avec les terminaisons électriques des condensateurs, la prise de contact électrique se faisant dans un secteur de rotation déterminé de la première roue correspondant à la mesure d'une caractéristique électrique,
- les moyens de prise de contact électrique sont reliés à un appareillage de mesure qui détermine les caractéristiques électriques des condensateurs,
- les moyens de transport comprennent également une deuxième roue rotative dans le même plan que et tangente à la première roue rotative sensiblement au niveau du point d'éjection et comportant des cases périphériques, chacune de ces cases étant destinée à recevoir au point d'éjection un condensateur éjecté de la première roue, cette deuxième roue comprenant également des moyens d'aspiration/soufflage destinés à maintenir les condensateurs dans leurs cases sur un angle de rotation déterminé qui est fonction, pour chaque condensateur, de ses caractéristiques électriques déterminées par l'appareillage de mesure.

L'invention sera mieux comprise, et d'autres avantages apparaîtront, à la lecture de la description qui va suivre, donnée à titre non limitatif, accompagnée des dessins annexés parmi lesquels

- la figure 1 représente un condensateur chips selon l'art connu,
- la figure 2 est une vue schématique du dispositif selon l'invention,
- les figures 3 et 4 représentent l'une des roues du dispositif selon l'invention, au cours de l'opération d'alimentation des alvéoles en condensateurs,
- la figure 5 est une vue en coupe d'une partie du dispositif selon l'invention,
- les figures 6 et 7 sont des vues de détail du dispositif selon l'invention.

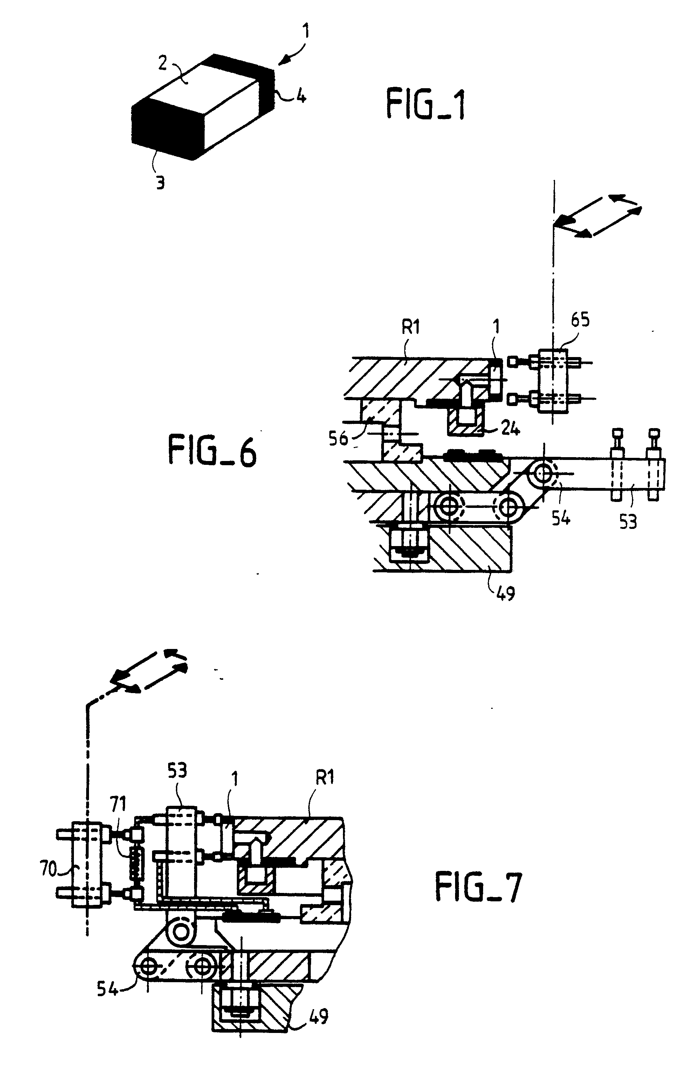

La figure 1 représente un condensateur du type chips fo 1 constitué d'un bloc parallélépipédique 2 équipé de terminaisons électriques 3 et 4. Ce peut être un condensateur multicouche céramique ou à film diélectrique métallisé. Les terminaisons électriques apparaissent donc selon deux côtés opposés. Selon les modèles, les dimensions de ces condensateurs chips peuvent varier. Il suffira alors de changer les roues du dispositif selon l'invention pour faire l'adaptation aux différents modèles et éventuellement de modifier leur entraxe.

Le dispositif selon l'invention comprend deux roues rotatives tangentes pourvues d'alvéoles périphériques dans lesquelles les condensateurs chips à contrôler seront maintenus par aspiration. La première roue est destinée à l'alimentation puis à la mesure des condensateurs. La seconde roue est destinée au classement des condensateurs suivant n cases.

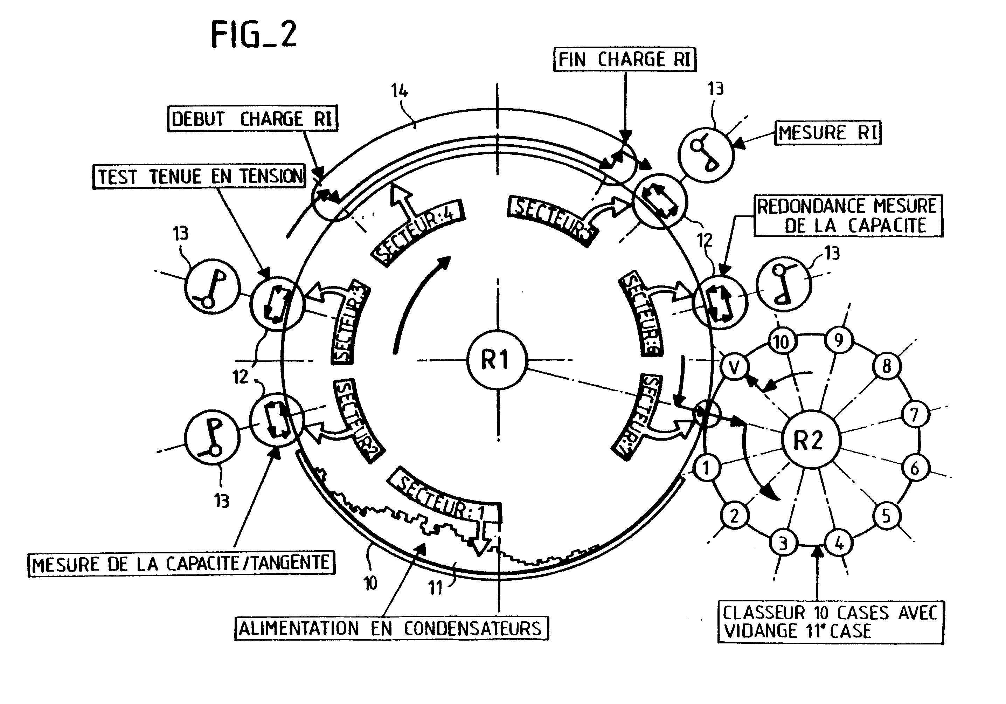

La figure 2 représente, de manière schématique, les deux roues du dispositif selon l'invention avec indication de leurs fonctions. R1 représente la première roue et R2 la seconde. Les roues sont entraînées en rotation dans le sens indiqué par les flèches.

Pour la première roue, on peut distinguer différents secteurs :
- le secteur 1 est celui de l'alimentation des alvéoles par les condensateurs chips,
- le secteur 2 est celui où est réalisée la mesure permettant de déterminer la capacité et la tangente de l'angle de pertes des condensateurs,
- le secteur 3 est celui où s'effectue le test de tenue en tension à 2,5 fois la tension nominale,
- le secteur 4 est celui où s'effectue la charge des condensateurs en vue de déterminer leur résistance d'isolement,
- le secteur 5 est celui où s'effectue la mesure de la résistance d'isolement,
- le secteur 6 est celui où l'on vérifie si les condensateurs n'ont pas souffert lors de leur charge ou lors de leur décharge pendant leur passage dans les secteurs précédents, cette vérification étant réalisée grâce à une nouvelle mesure de capacité,

- le secteur 7 est celui du transfert des composants vers la seconde roue.

Pour la seconde roue, 10 cases de tri et une case V d'éjection systématique des pièces défectueuses ont été représentées.

Le dispositif selon l'invention présente l'avantage suivant que les roues peuvent avoir une cinématique du type continu.

Pour que le remplissage des alvéoles se fasse le plus correctement possible, il est avantageux que la roue R1 (et par conséquent la roue R2) soit inclinée de façon que la partie basse serve de bol d'alimentation grâce à la présence de la jupe fixe 10. Sous la référence 11, on a représenté une certaine quantité de condensateurs chips prêts à être contrôlés.

La prise de contact électrique avec les terminaisons peut se faire par des pinces qui accompagnent le composant sur une certaine longueur de son transit, et représentées sous la référence 12. Elle peut se faire au moyen de contacts glissants, qui eux sont fixes, et représentés sous la référence 13.

Sous la référence 14, on a figuré la zone de charge des condensateurs en vue de la mesure de la résistance d'isolement $R_i$.

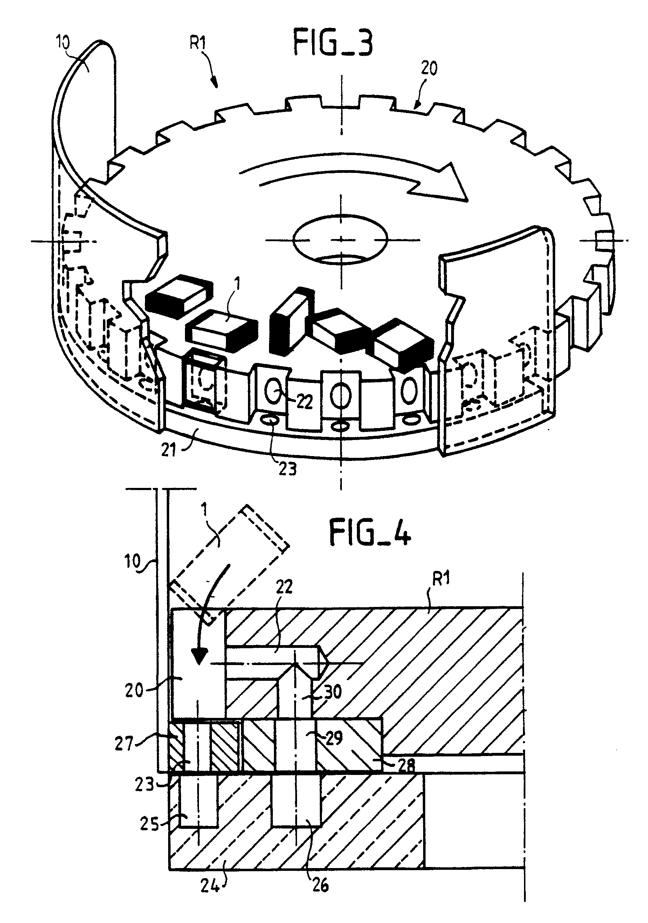

L'alimentation des alvéoles en condensateurs se fait de la façon suivante, en relation avec la figure 3. Les condensateurs 1 peuvent être distribués dans le bol d'alimentation à partir d'un système comportant une régulation de débit de façon à en fournir un nombre suffisant mais pas trop important. Les composants tombent sur la roue R1, inclinée par exemple à 45°, et s'orientent par gravité en direction des alvéoles 20 régulièrement réparties à la périphérie de la roue. La roue R1 constitue donc une roue dentée. Elle doit être réalisée dans une matière isolante pour éviter les courts-circuits électriques. Le bol d'alimentation comprend aussi un fond fixe 21 circulaire placé sous la roue R1 et fermant les alvéoles vers le bas pour un secteur angulaire limité au secteur d'alimentation, ainsi qu'une jupe fixe 10 retenant les composants livrés en vrac et couvrant le même secteur angulaire.

Sur la figure 3, on distingue aussi les trous d'aspiration/soufflage 22 usinés radialement dans l'épaisseur de la roue R1, ainsi que des trous d'aspiration 23 usinés perpendiculairement et à la périphérie du fond fixe 21.

La jupe 10 peut être une pièce animée d'un mouvement de vibration pour améliorer le remplissage des alvéoles. Elle peut être réalisée à partir d'une tôle cintrée en arc de cercle selon un diamètre légèrement supérieur à la roue R1. Elle assure un guidage des chips.

La combinaison du guidage des chips et du mouvement continu de rotation de la roue permet une alimentation des alvéoles avec un très bon rendement. Les chips guidés dans les alvéoles sont ensuite maintenus par aspiration grâce aux trous 22 de la roue R1. Les pièces ainsi maintenues se déplacent ensuite en direction des secteurs de mesure.

Les dimensions des alvéoles sont telles que lorsqu'un composant est placé dans une alvéole, on peut avoir accès à ses terminaisons électriques par les faces inférieure et supérieure de la roue.

En fait, le fond fixe 21 est formé de plusieurs parties : une plaque 24, un élément complémentaire 27 et une pièce d'usure 28.

La plaque 24 de forme circulaire peut être en laiton. Un premier secteur de cette plaque a un diamètre suffisant pour fermer les alvéoles dans la partie bol d'alimentation. Un second secteur de cette plaque a un diamètre plus petit de façon à ne pas obturer les alvéoles pour pouvoir effectuer les mesures. La plaque 24 possède plusieurs rainures : des rainures d'aspirations 25 et 26 et une rainure de soufflage non représentée.

Un élément complémentaire 27 en arc de cercle et percé de trous 23 est fixé à la plaque 24 et assure l'aspiration des chips dans les alvéoles. Son épaisseur est légèrement inférieure à l'élément 28 voisin pour qu'il ne soit pas en contact avec la roue R1. Il peut être réalisé en acier inoxydable.

L'élément 28 est une pièce d'usure fixée A la roue R1. Il est réalisé en matière isolante. Il assure la liaison entre la plaque 24 et les alvéoles 20 pour les fonctions d'aspiration/soufflage. Dans le cas de la figure 4, l'élément 28 est pourvu de trous 29 correspondant à la rainure 26 et donnant accès au trou 30 percé dans la roue R1 et débouchant dans le trou 22.

La réalisation de ces fonctions d'aspiration/soufflage ne pose pas de problème particulier à l'homme du métier. Les alvéoles sont conçues pour ne recevoir qu'un condensateur à la fois.

La mesure simultanée des paramètres capacité et tangente s'effectue dans le secteur 2 de la roue R1. Une pince de mesure constituée de deux pistons animés d'un mouvement de va-et-vient ou de deux contacts glissants, selon l'art connu, est appliquée sur les deux terminaisons soudables de chaque condensateur. Les signaux électriques relevés par ces pinces sont transmis vers un pont de mesure. La mesure des condensateurs est synchronisée (durée d'environ 30 ms) par rapport au mouvement de la roue R1. L'appareil de mesure fonctionne sur une pièce à la fois, pour une fréquence de 1 kHz ou de 1 MHz et pour une tension de 0,5 à 1 V.

La mesure de la tenue en tension des condensateurs s'effectue dans le secteur 3 de la roue R1. Suivant le même principe que pour la mesure de capacité/tangente, une pince de mesure permet d'appliquer sur les terminaisons du condensateur à tester une tension continue égale à 2,5 fois la tension nominale, pendant un temps inférieur à 50 ms.

La charge des condensateurs s'effectue dans le secteur 4. C'est une opération qui dure de 4 à 6 secondes et qui est toujours réalisée selon une cinématique continue, à partir d'une roue secondaire à la roue R1 et qui lui est coaxiale. Cette roue secondaire alimente l'ensemble des condensateurs du secteur 4 par des pinces de charge.

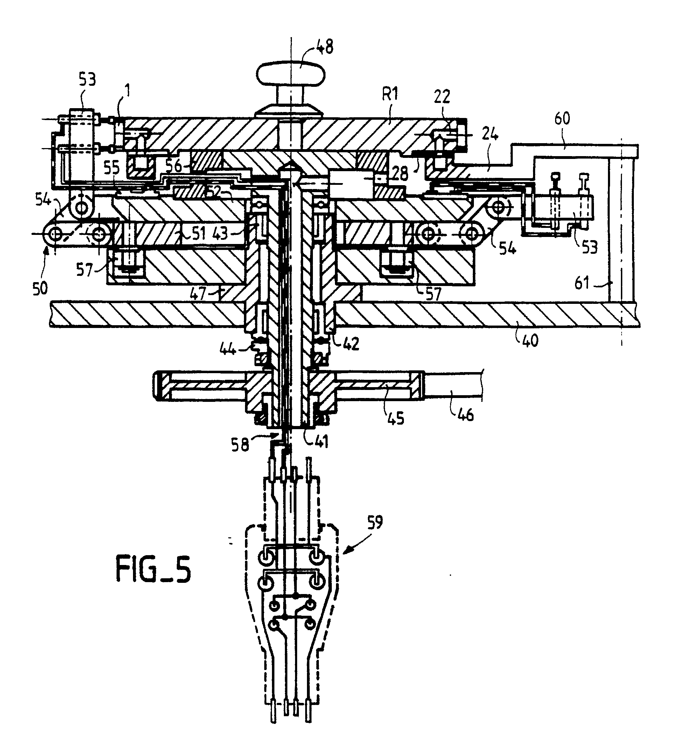

La figure 5 est une vue en coupe d'une partie du dispositif selon l'invention, la coupe étant réalisée selon l'axe de la roue R1. Le dispositif comprend un châssis 40 percé d'un trou dans l'axe de la roue R1. Dans ce trou du châssis 40 ou fixe un manchon 42 dans lequel peut tourner l'arbre creux 41 grâce aux roulements à billes 43 et 44. L'arbre 41 sera entraîné en rotation par la poulie 45 placée sous le châssis 40 et entraînée par la courroie 46. L'arbre 41 supporte à son sommet la roue R1 qui lui est fixée par la vis 48. Une collerette 47 du manchon 42 supporte la came fixe 49.

La roue secondaire correspond à la référence 50. Elle est formée d'un plateau 52 et de coulisseaux 51 solidaires en rotation du plateau 52 mais pouvant glisser axialement par rapport à lui. Le plateau 52 tourne au rythme de la roue R1. Les coulisseaux 51 suivent une trajectoire imposée par la came fixe 49, grâce aux galets 57. Ils supportent les pinces de charge 53 par des bras articulés 54. Le plateau 52, réalisé par exemple en acier, supporte une piste électrique 55 à 2 voies. Une entretoise circulaire 56 rend solidaire la roue R1 et le plateau 52 et permet le passage des fils électriques 58 reliant la piste 55 aux contacts à mercure 59 via l'intérieur de l'arbre 41. Les contacts à mercure transmettent la tension de charge des condensateurs provenant d'un générateur de tension continue non représenté.

La plaque 24 se prolonge par un bras 60 permettant sa fixation au châssis 40 par un support 61. Grâce au mouvement des coulisseaux 51 par rapport à la came fixe 49, les pinces de charge 53 peuvent soit être en position fermée (c'est-à-dire en contact électrique avec les terminaisons des condensateurs), soit en position ouverte (c'est-à-dire sans contact électrique avec ces terminaisons). Ainsi, les pinces de charge sont en position fermée lors de leur passage dans le secteur 4 correspondant à la charge des condensateurs. Elles sont encore en position fermée pendant la mesure de la résistance d'isolement (secteur 5) mais leur fonction est différente comme il sera dit plus loin.

La roue secondaire 50, solidaire de la roue R1 permet donc de relier les pinces de charge 53 à un générateur de tension continue par l'intermédiaire de contacts tournants du type à mercure par exemple.

La figure 5 montre le dispositif selon l'invention alors que l'un des condensateurs véhiculés par la roue R1 (celui situé à gauche de la figure) est en position de charge, c'est-à-dire qu'il transite dans le secteur 4 et que la charge s'effectue grâce à une pince de charge entraînée par la roue secondaire.

La figure 6 est une vue de détail du dispositif selon l'invention qui montre un condensateur 1 véhiculé par la roue R1 en passe d'être accosté par une pince de mesure 65 correspondant au secteur 2 (mesure de capacité/tangente), ou au secteur 3 (test de tenue en tension), ou au secteur 6 (nouvelle mesure de capacité). Cette pince de mesure 65, rattachée mécaniquement à une partie de la machine environnant la roue R1, est animée d'un mouvement de va-et-vient figuré par les quatre flèches placées au-dessus de la pince 65.

La figure 7 est une vue de détail du dispositif selon l'invention qui montre un condensateur 1 véhiculé par la roue R1 et en position de mesure de la résistance d'isolement. La pince de mesure 70 correspondant au secteur 5 (mesure de la résistance d'isolement) ne prend pas directement contact avec les terminaisons électriques du condensateur 1. Elle le fait par l'intermédiaire de la pince 53 et de la résistance de charge 71. La mise en position de la pince de mesure 70 provoque la mise en circuit d'un millivoltmètre non représenté permettant la lecture de la tension aux bornes de la résistance de charge 71 et on obtient un circuit comprenant en série : un générateur de tension continue, un condensateur 1 et une résistance de charge 71 en parallèle avec l'appareil de mesure de la tension. La pince de mesure est placée aux bornes de la résistance de charge. Elle est aussi animée d'un mouvement de va-et-vient figuré par les quatre flèches placées au-dessus de la pince 70. Elle est rattachée mécaniquement à la partie de la machine environnant la roue R1. La mesure de la résistance d'isolement dure environ 50 ms.

Les pinces de mesures sont reliées à l'appareillage de mesure par un circuit non représenté sur les figures.

Afin de vérifier que les condensateurs n'ont pas subi de détérioration lors du test de tenue en tension et lors de la mesure de la résistance d'isolement, on vérifie dans le secteur 6 la valeur de leur capacité. Le principe de mesure est identique à celui utilisé dans le secteur 2. Au préalable, une paire de contacts glissants permet la décharge des condensateurs.

La fonction tri s'effectue sur la deuxième roue R2. Au préalable, les condensateurs testés sont transférés de la première roue à la deuxième par soufflage au point de tangence des deux roues. La deuxième roue, bien que dépourvue d'alvéoles, dispose de trous d'aspirations similaires à ceux décrits précédemment pour la première roue et définissant des cases périphériques. Les deux roues sont parfaitement synchronisées entre elles et assurent un bon échange de composants. La deuxième roue comprend n + 1 cases de tri. A chaque case correspond une boîte réceptionnant les composants triés.

Au droit de chaque case est disposé un système d'éjection à cinématique continue. L'éjecteur, animé d'un mouvement de rotation selon un axe perpendiculaire à la roue R2, est constitué d'éléments mécaniques (2 au minimum pour une cadence de 40 000 pièces par heure) pilotés pneumatiquement ou électriquement. Les éléments mécaniques sont activés par le système d'automatisme suivant la caractéristique du condensateur mesuré et viennent balayer la pièce et l'éjecter en direction de la boîte considérée. Si l'éjection n'a pas été demandée, l'élément mécanique bien que toujours animé d'un mouvement de rotation ne vient pas éjecter la pièce. Ainsi chaque condensateur sera poussé vers une case du tri. Dans le dernier secteur de la roue R2, un élément mécanique éjecte toutes les pièces restant sur la roue. Ce secteur correspond à la case vidange V.

Les condensateurs non correctement transférés sur la deuxième roue R2 pour tri sont éjectés systématiquement pour non recyclage sur la roue R1, ceux-ci étant le plus souvent des pièces cassées ou hors cote.

Le dispositif selon l'invention permet le passage de différents formats. Le changement de format est effectué par le remplacement de la roue R1. La roue R2 de classement peut rester commune à l'ensemble des formats mais il peut être nécessaire de modifier l'entraxe entre les deux roues.

L'ensemble du dispositif étant conçu selon une cinématique continue, le principe apporte un fonctionnement sans chocs, avec une moindre usure et un confort dû au silence de fonctionnement.

La mesure de la capacité à 1 MHz étant assurée unitairement (sans scanner), ceci permet d'apprécier à grande cadence et avec une bonne précision le paramètre tangente.

Le système d'alimentation permet d'obtenir des cadences élevées grâce à un très bon taux de remplissage des alvéoles.

Les systèmes de mesure ont des temps de mesure très courts (inférieur à 50 ms) et assurent une bonne cadence.

Le système de tri travaille par action positive, c'est-à-dire que l'on éjecte les pièces bonnes. En cas de défaut, les pièces vont alors systématiquement dans les déchets. Il n'autorise pas le recyclage de pièces coincées ou cassées.

Le dispositif selon l'invention dispose d'un contrôle redondant afin d'éliminer les pièces qui auraient pu être détériorées lors du test en tension. Il est compact avec une surface au sol réduite.

## Revendications

1 - Dispositif de contrôle et de tri de condensateurs chips, le dispositif possédant des moyens de transport des condensateurs à contrôler depuis une zone d'alimentation jusqu'à une zone de triage, le contrôle consistant à mesurer des caractéristiques électriques des condensateurs pendant une partie de leur transit sur les moyens de transport, caractérisé en ce que :
- les moyens de transport comprennent une première roue rotative dont l'axe de rotation fait un angle compris entre 0 et 45° par rapport à la verticale et comportant des alvéoles périphériques, chacune de ces alvéoles étant destinée à recevoir, dans la zone d'alimentation, un condensateur à contrôler, la roue comportant des moyens d'aspiration/soufflage destinés à maintenir les condensateurs dans leurs alvéoles sur un angle de rotation déterminé de la roue et à les éjecter en un point déterminé dit point d'éjection,
- la mesure des caractéristiques électriques se fait par des moyens de prise de contact électrique avec les terminaisons électriques des condensateurs, la prise de contact électrique se faisant dans un secteur de rotation déterminé de la première roue correspondant à la mesure d'une caractéristique électrique,
- les moyens de prise de contact électrique sont reliés à un appareillage de mesure qui détermine les caractéristiques électriques des condensateurs,
- les moyens de transport comprennent également une deuxième roue rotative dans le même plan que et tangente à la première roue rotative sensiblement au niveau du point d'éjection et comportant des cases périphériques, chacune de ces cases étant destinée à recevoir au point d'éjection un condensateur éjecté de la première roue, cette deuxième roue comprenant également des moyens d'aspiration/soufflage destinés à maintenir les condensateurs dans leurs cases sur un angle de rotation déterminé qui est fonction, pour chaque condensateur, de ses caractéristiques électriques déterminées par l'appareffiage de mesure.

2 - Dispositif selon la revendication 1, caractérisé en ce que la première roue (R1) décrit sept secteurs : un secteur d'alimentation des alvéoles (20) en condensateurs chips (1), un secteur de mesure de la capacité et de la tangente de l'angle de pertes des condensateurs, un secteur de test de tenue en tension, un secteur de charge des condensateurs, un secteur de mesure de la résistance d'isolement, un secteur où l'on mesure à nouveau la capacité des condensateurs et un secteur de transfert des condensateurs vers la deuxième roue (R2).

3 - Dispositif selon l'une des revendications 1 ou 2, caractérisé en ce que les moyens de prise de contact électrique sont constitués par des pinces de mesures (12, 65, 70).

4 - Dispositif selon la revendication 3, caractérisé en ce que les pinces de mesure (12, 65, 70) accompagnent les condensateurs pendant une partie de leur transit sur la première roue (R1).

5 - Dispositif selon l'une quelconque des revendications 2 à 4, caractérisé en ce que la charge des condensateurs s'effectue par l'intermédiaire de pinces de charge (53) accompagnant les condensateurs durant leur transit sur le secteur de charge.

6 - Dispositif selon la revendication 5, caractérisé en ce que les pinces de charge (53) sont solidaires d'une roue secondaire (50) et coaxiale à la première roue (RI), cette roue secondaire tournant au rythme de la première roue, des moyens de commande des pinces de charge permettant soit leur mise en position pour charger les condensateurs, soit leur retrait de la partie périphérique de la première roue (R1).

7 - Dispositif selon la revendication 6, caractérisé en ce que les moyens de commande comprennent une came fixe (49) et des coulisseaux (51) supportant les pinces de charge (53), le mouvement des coulisseaux par rapport à la came fixe mettant les pinces de charge en position fermée, c'est-à-dire dans la position correspondant à la charge des condensateurs, tant dans le secteur de charge que dans le secteur de la résistance d'isolement.

8 - Dispositif selon les revendications 3 et 7, caractérisé en ce que les pinces de mesure de la résistance d'isolement (70) prennent contact avec les condensateurs (1) par l'intermédiaire des pinces de charge (53), cette prise de contact introduisant une résistance de charge (71) en série avec chaque condensateur.

9 - Dispositif selon l'une quelconque des revendications 1 à 8, caractérisé en ce que la première roue (R1) est inclinée pour que sa partie basse serve de bol d'alimentation grâce à la présence d'une jupe fixe (10).

FIG_1

FIG_6

FIG_7

# FIG_2

EP 0 427 611 A1

FIG_3

FIG_4

FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | FR-A-2 381 571 (MOTOROLA INC.)<br>* Page 2, ligne 21 - page 4, ligne 20; figures * | 1 | B 07 C    5/344 |
| A | US-A-3 750 878 (R.D. ATCHLEY et al.)<br>* Colonne 3, ligne 13 - colonne 4, ligne 9; colonne 6, lignes 1-66; colonne 7, lignes 1-12; figure * | 1,3 | |
| A | US-A-3 930 993 (H.S. BEST et al.) | | |

DOMAINES TECHNIQUES
RECHERCHES (Int. Cl.5)

B 07 C
H 01 G
H 01 R

Le présent rapport a été établi pour toutes les revendications

| Lieu de la recherche | Date d'achèvement de la recherche | Examinateur |
|---|---|---|
| LA HAYE | 12-02-1991 | SCHUERMANS N.F.G. |